# FASCICULE DE BREVET EUROPEEN

(11) **EP 1 989 716 B1**
(45) Date de publication et mention de la délivrance du brevet: **23.11.2016**
(21) Numéro de dépôt: 07730902.9
(22) Date de dépôt: 01.02.2007
(51) Int. Cl.: H01F 41/30, H01F 1/40, G01R 33/09, C30B 29/52, C30B 23/06, B82Y 40/00, B82Y 25/00, H01F 10/193

(54) **SEMI-CONDUCTEUR FERROMAGNETIQUE, SON PROCEDE DE FABRICATION, COMPOSANTS L'INCORPORANT ET UTILISATIONS DE CE SEMI-CONDUCTEUR S'Y RAPPORTANT**
FERROMAGNETISCHER HALBLEITER, VERFAHREN ZU DESSEN HERSTELLUNG, BAUELEMENTE, DIE DIESEN HALBLEITER INTEGRIEREN, UND ENTSPRECHENDE VERWENDUNGEN DIESES HALBLEITERS
FERROMAGNETIC SEMICONDUCTOR, METHOD FOR THE PRODUCTION THEREOF, COMPONENTS INCORPORATING THE SAME, AND CORRESPONDING USES OF SAID SEMICONDUCTOR

(30) Priorité: 09.02.2006 FR 0601149
(43) Date de publication de la demande: 12.11.2008
(73) Titulaire: Commissariat à l'Énergie Atomique et aux Énergies Alternatives, 75015 Paris (FR)
(72) Inventeur: JAMET, Matthieu, F-38500 Voiron (FR); SAMSON, Yves, F-38000 Grenoble (FR); BARSKI, André, F-38430 Moirans (FR); DEVILLERS, Thibaut, F-38000 Grenoble (FR)
(74) Mandataire: Gevers & Orès
(86) Numéro de dépôt international: PCT/FR2007/000186
(87) Numéro de publication internationale: WO 2007/090946

(56) Documents cités:
- US-A- 3 850 706
- US-A1- 2005 006 673
- US-B1- 6 307 241
- HIRO AKINAGA ET AL: "Semiconductor Spintronics" IEEE TRANSACTIONS ON NANOTECHNOLOGY, IEEE, NEW YORK, NY, US, vol. 1, no. 1, mars 2002 (2002-03), XP011077057 ISSN: 1536-125X
- YOSHIO MIURA ET AL: "First-principles design of ferromagnetic nanostructures based on group-IV semiconductors" JOURNAL OF PHYSICS: CONDENSED MATTER, INSTITUTE OF PHYSICS PUBLISHING, BRISTOL, GB, vol. 16, no. 48, 8 décembre 2004 (2004-12-08), pages S5735-S5738, XP020060478 ISSN: 0953-8984

## Description

La présente invention concerne un semi-conducteur ferromagnétique du groupe IV, son procédé de fabrication, un composant électronique formant une diode pour l'injection ou la collecte de spins dans ou depuis un autre semi-conducteur, respectivement, ou bien de type élément sensible à un champ magnétique, et des utilisations de ce semi-conducteur relatives à ce composant. L'invention s'applique notamment à l'injection ou la collecte d'un courant de porteurs polarisé en spin dans ou depuis un semi-conducteur et à la mesure de champs magnétiques, via un tel semi-conducteur ferromagnétique.

L'injection dans un semi-conducteur d'un courant de porteurs polarisé en spin, qui se caractérise par un excès de l'une des deux populations de porteurs présentes (par exemple celle de spin parallèle ou « spin up »), a récemment fait l'objet de plusieurs publications. On peut par exemple citer, à titre exemplatif, les composants électroniques décrits dans l'article Datta et Das, Applied Physics Letters, 56, 665, 1990.

La mise en oeuvre de cette injection d'un courant polarisé en spin présente un grand intérêt en microélectronique, mais son développement se heurte au manque de matériaux appropriés pour constituer l'électrode d'injection du courant.

En effet, si les métaux ferromagnétiques usuels, tels que le fer et nombre de ses alliages, présentent une part des qualités requises comme une polarisation en spin élevée et un comportement ferromagnétique à température ambiante, leur résistance électrique est de plusieurs ordres de grandeur différente de celle des semi-conducteurs, ce qui génère de grandes difficultés de mise en oeuvre et impose d'effectuer l'injection de courant par effet tunnel. Cela a pour inconvénient de nécessiter la croissance d'une hétéro-structure hybride malaisée à réaliser, du type semi-conducteur/ barrière à effet tunnel/ métal ferromagnétique.

A l'opposé, il existe des semi-conducteurs dits magnétiques dilués (en abrégé « DMS » en anglais, pour « Diluted Magnetic Semiconductors ») qui ne présentent pas cet inconvénient de posséder une résistivité très différente de celle des semi-conducteurs ordinaires. Ces « DMS » sont typiquement constitués d'une matrice semi-conductrice des groupes III-V, IV ou II-VI dans laquelle sont diluées des impuretés magnétiques comme le manganèse, le fer, le chrome, le cobalt ou le nickel.

Dans le cas d'une dilution au manganèse, qui est un accepteur dans les semi-conducteurs III-V ou IV, les porteurs de charge sont constitués de trous. Lorsque la concentration en manganèse et la densité de trous (naturellement créés par la présence du manganèse ou volontairement introduits par co-dopage) sont suffisamment élevées dans le « DMS », ce dernier peut devenir ferromagnétique et le couplage d'échange entre ions manganèse est induit par les trous.

Un inconvénient majeur de ces « DMS » est qu'ils présentent tous à ce jour une température de Curie Tc (température jusqu'à laquelle le semi-conducteur présente des propriétés ferromagnétiques) inférieure ou égale à la température ambiante (typiquement ≤ 300 K environ). On pourra par exemple se référer à l'article K. W. Edmonds et al., Phys. Rev. Lett. 92, 037201, 2004, qui décrit un semi-conducteur de formule GaMnAs présentant une température de Curie d'environ 159 K seulement, et à l'article H. Saito et al., Phys. Rev. Lett. 90, 207202, 2003, qui décrit des « DMS » répondant à la formule Zn₁₋ₓCrₓTe et présentant une température de Curie sensiblement égale à 300 K (± 10 K), lorsque x = 0,20.

Un autre inconvénient de ces « DMS » réside dans la formation indésirable mais fréquente de petits précipités métalliques ferromagnétiques au sein de la matrice semi-conductrice, ce qui ne plaide pas en faveur de propriétés réellement ferromagnétiques pour ces « DMS » et rend l'étape de croissance des cristaux très difficile à réaliser.

On notera en outre que la mise en oeuvre de ces matériaux à base de gallium ou de tellure est très difficile à concevoir sur des substrats en silicium, matériau de base de l'industrie microélectronique.

Le document de Brevet US-B-6 946 301 divulgue un procédé de fabrication par évaporation thermique d'un semi-conducteur ferromagnétique de type GeMn, qui présente une température de Curie pouvant atteindre 250 K, pour un taux de manganèse d'environ 35 %.

Le document de Brevet US-B-6 307 241 enseigne, dans son unique exemple de réalisation, de fabriquer un semi-conducteur ferromagnétique de type III-V (GaAs) de température de Curie Tc supérieure à 400 K, par la technique d'implantation ionique d'ions manganèse (Mn⁺) suivie d'un recuit. Comme cela est connu de l'homme du métier (voir notamment l'article Magnetooptical Study of Mn ions Implanted in Ge, Franco D'Orazio et al., IEEE Transactions on Magnetics, Vol. 38, No. 5, September 2002), on notera que cette technique d'implantation n'est pas adaptée à la fabrication de semi-conducteurs ferromagnétiques du groupe IV (typiquement à base de germanium) de Tc ≥ 350 K, étant précisé que la phase ainsi obtenue, de type Ge₃Mn₅, présente une Tc n'excédant jamais 300 K.

Le document US-A-3 850 706 n'enseigne pas non plus la mesure de températures de Curie supérieures à 300 K en relation avec des semi-conducteurs ferromagnétiques du groupe IV, mais uniquement avec des semi-conducteurs de formule Mn₁₋ₓMₓGaGe (où M peut être Fe, Ni, Co, Cu, Cr, V, Ti) et contenant ainsi un élément du groupe III (Ga).

Un inconvénient majeur de ces semi-conducteurs magnétiques connus, de type dilués ou bien ferromagnétiques, réside dans leur température de Curie relativement basse, qui est généralement limitée à environ 300 K. De plus, lorsque la température de Curie mesurée est proche de 300 K, il est difficile d'exclure la présence de la phase métallique Ge₃Mn₅, dont la température de Curie est précisément proche de 300 K.

Un but de la présente invention est de proposer un semi-conducteur ferromagnétique qui permette de remédier aux inconvénients précités, et ce but est atteint en ce que la Demanderesse a découvert d'une manière inattendue que si l'on forme, dans une couche mince formée d'un semi-conducteur du groupe IV comprenant au moins un élément magnétique choisi dans le groupe constitué par le manganèse, le fer, le cobalt, le nickel et le chrome, une matrice pauvre en cet ou ces élément(s) magnétique(s) à l'intérieur de laquelle est formée une phase discontinue riche en cet ou ces élément(s) magnétique(s) de sorte à générer une modulation latérale de la composition du semi-conducteur dans le plan de la couche mince, alors on obtient un semi-conducteur ferromagnétique présentant une température de Curie égale ou supérieure à 350 K et, avantageusement, égale ou supérieure à 400 K.

On notera que cette phase ferromagnétique à haute température de Curie provient des zones enrichies en ledit ou lesdits élément(s) magnétique(s) introduit(s).

A la connaissance de la Demanderesse, ces valeurs très élevées de températures de Curie, mesurées via un magnétomètre de type à « SQUID » (i.e. « Superconducting Quantum Interference Device », ou détecteur d'énergie quantique à supraconducteurs), n'ont jamais été atteintes à ce jour pour des semi-conducteurs ferromagnétiques du groupe IV.

Selon une autre caractéristique de l'invention, ledit semi-conducteur ferromagnétique présente également un effet Hall extraordinaire (« EHE » en abrégé) à une température supérieure à 300 K et pouvant atteindre au moins 400 K.

Toujours à la connaissance de la Demanderesse, ces valeurs très élevées de températures où se manifeste cet effet « EHE », températures mesurées via un banc de magnéto-transport équipé d'un cryostat et d'une bobine supraconductrice, n'ont jamais été atteintes à ce jour pour des semi-conducteurs ferromagnétiques du groupe IV.

De préférence, on utilise le manganèse à titre dudit ou de l'un au moins desdits élément(s) magnétique(s), pour l'obtention de températures de Curie - et de températures ou se produit ledit effet « EHE » - maximales.

Egalement à titre préférentiel, ledit semi-conducteur ferromagnétique selon l'invention est à base d'au moins un autre élément choisi dans le groupe constitué par le germanium, le silicium et leurs alliages.

Encore plus préférentiellement, ledit semi-conducteur ferromagnétique selon l'invention est à base de germanium et de manganèse, répondant ainsi avantageusement à la formule GeMn ou, en variante, à une formule de type GeMnX, où X est un métal ou un alliage d'un métal pouvant être par exemple le fer, le cobalt le nickel ou le chrome.

Dans le cas préférentiel d'un semi-conducteur GeMn, on notera que ladite phase discontinue riche en manganèse ne présente pas une composition similaire à celle des composés connus du diagramme de phase de l'alliage binaire GeMn, i.e. Ge₃Mn₅ ou Ge₈Mn₁₁. Ainsi, ledit semi-conducteur ferromagnétique selon l'invention est totalement dépourvu de phase métallique de formule Ge₃Mn₅, laquelle est connue pour ne pas procurer des propriétés semi-conductrices.

Avantageusement, la fraction atomique de cet ou ces élément(s) magnétique(s) dans ladite phase discontinue est comprise entre 5 % et 50 %.

Encore plus avantageusement, la fraction atomique de cet ou ces élément(s) magnétique(s), tel que le manganèse, dans ladite phase discontinue et dans ladite matrice est comprise entre 20 % et 40 % et entre 1 % et 10 %, respectivement.

Selon une autre caractéristique de l'invention, ladite phase discontinue comprend une répartition irrégulière de zones volumiques riches en cet ou ces élément(s) magnétique(s) qui sont séparées entre elles par ladite matrice. Ladite répartition irrégulière n'exclut pas, dans certaines conditions de croissance présentées dans l'invention, l'apparition d'une distance ou/et d'une organisation caractéristiques entre les zones volumiques riches en cet ou ces élément(s) magnétique(s).

Avantageusement, lesdites zones volumiques sont respectivement formées par des colonnes sensiblement perpendiculaires à la surface de ladite couche mince, qui présentent de préférence un diamètre moyen compris entre 1 nm et 10 nm, pour une épaisseur de ladite couche mince par exemple comprise entre 60 nm et 100 nm.

Encore plus avantageusement, lesdites colonnes, qui sont formées en étant sensiblement parallèles entre elles dans la masse dudit semi-conducteur, sont séparées entre elles d'une distance moyenne comprise entre 5 nm et 15 nm.

Un procédé de fabrication selon l'invention dudit semi-conducteur ferromagnétique consiste en une épitaxie par jets moléculaires comprenant un dépôt simultané d'au moins un élément magnétique choisi dans le groupe constitué par le manganèse, le fer, le cobalt, le nickel et le chrome et d'au moins un autre élément choisi dans le groupe IVA de la classification périodique, sur un substrat dont la température pendant la croissance des cristaux est comprise entre 80° C et 200° C (préférentiellement entre 100° C et 150° C), pour l'obtention d'une couche mince dudit semi-conducteur du groupe IV.

On notera que cette température de croissance est très inférieure aux températures de croissance comprises entre 550° C et 600° C qui sont communément utilisées dans l'épitaxie de matériaux semi-conducteurs du groupe IV, et que cette basse température de croissance selon l'invention permet de stabiliser les phases métastables semi-conductrices obtenues qui sont riches en élément(s) magnétique(s) et qui sont ferromagnétiques.

Avantageusement, on réalise ledit dépôt desdits éléments en utilisant un rapport moyen [vitesse de dépôt du ou des élément(s) magnétique(s) / vitesses de dépôt de l'ensemble desdits éléments] qui est compris entre 5 % et 10 %.

On notera que les paramètres essentiels dans ce procédé selon l'invention sont notamment la température du substrat pendant le dépôt, les flux respectifs dudit élément magnétique et dudit élément du groupe IVA pendant le dépôt, ainsi que l'épaisseur de la couche mince du semi-conducteur obtenu. On comprendra que ces paramètres peuvent être modifiés dans une certaine mesure, tout en conduisant à un semi-conducteur ferromagnétique selon l'invention présentant une température du Curie d'au moins 350 K et avantageusement d'au moins 400 K, grâce à une structure en colonnes telle que susmentionnée mais dont la taille des colonnes, la concentration en élément(s) magnétique(s) dans celles-ci et leur densité dans la couche mince (i.e. l'espacement entre colonnes) peuvent être différentes de celles indiquées précédemment.

De préférence, ledit ou l'un au moins desdits élément(s) magnétique(s) est le manganèse.

Egalement à titre préférentiel, le(s)dit(s) autre(s) élément(s) déposés simultanément sont le germanium, le silicium ou un de leurs alliages.

Encore plus préférentiellement, ledit élément magnétique et ledit autre élément déposés simultanément sont respectivement le manganèse et le germanium, pour l'obtention d'un semi-conducteur GeMn ou SiMn voire SiGeMn, ou bien, en variante, de type GeMnX, SiMnX voire SiGeMnX où X est un métal ou un alliage d'un métal pouvant être par exemple le fer, le cobalt le nickel ou le chrome.

Avantageusement, ledit procédé selon l'invention comprend en outre un dépôt sur ledit substrat d'une couche « tampon » de germanium, antérieurement audit dépôt simultané de germanium et de manganèse pour l'obtention de ladite couche mince, de sorte à obtenir une surface la plus lisse possible à l'échelle atomique pour une croissance bidimensionnelle du film de germanium-manganèse.

De préférence, ledit substrat utilisé pour mettre en oeuvre ce procédé est à base d'un matériau choisi dans le groupe constitué par le germanium, le silicium et les alliages de ces derniers.

Un composant électronique selon l'invention peut être avantageusement de type diode pour l'injection ou la collecte de spins dans ou depuis un autre semi-conducteur, respectivement, ou bien de type élément sensible à un champ magnétique, et ce composant comporte avantageusement un semi-conducteur ferromagnétique selon l'invention tel que défini ci-dessus.

Selon un premier mode de réalisation de l'invention, il s'agit d'un composant de type diode pour l'injection ou la collecte de spins dans ou depuis un autre semi-conducteur par exemple du groupe IV, comportant :
- une première couche mince formée d'un premier semi-conducteur ferromagnétique selon l'invention tel que défini ci-dessus,
- une seconde couche mince formée d'un second semi-conducteur à base de silicium, de germanium ou d'un de leurs alliages, au contact de laquelle est appliquée ladite première couche mince, et
- une source de courant de porteurs couplée à ladite première couche pour, dans un premier cas, en extraire sélectivement un courant polarisé en spin et pour l'injecter dans ladite seconde couche ou bien, dans un second cas, pour extraire sélectivement un courant de porteurs polarisés en spin depuis ladite seconde couche et l'injecter dans ladite première couche,
pour que ladite phase ferromagnétique discontinue et riche en élément(s) magnétique(s) dudit premier semi-conducteur émette ou reçoive ce courant polarisé en spin vers ou depuis ledit second semi-conducteur, respectivement selon lesdits premier ou second cas.

Plus précisément selon ce premier mode de l'invention :
- ledit semi-conducteur présente ladite matrice à l'intérieur de laquelle est formée ladite phase ferromagnétique discontinue, de sorte à générer la modulation latérale précitée,
- la fraction atomique de cet ou ces élément(s) magnétique(s) dans ladite phase est avantageusement comprise entre 5 % et 50 % et de préférence entre 20 % et 40 %, la fraction atomique de cet ou ces élément(s) magnétique(s) dans ladite matrice étant alors avantageusement comprise dans ce dernier cas entre 1 et 10 %,
- ladite phase comprend une répartition irrégulière de zones volumiques riches en cet ou ces élément(s) magnétique(s) qui sont séparées entre elles par ladite matrice et qui sont respectivement formées par des colonnes sensiblement perpendiculaires à la surface de la couche mince et qui sont telles que définies ci-dessus.

Selon une autre caractéristique de ce premier mode de l'invention, ledit premier semi-conducteur ferromagnétique est tel que défini ci-dessus en relation avec lesdites colonnes, pour que lesdites première et seconde couche minces appliquées l'une sur l'autre forment une diode d'Esaki à effet tunnel, dans laquelle lesdites colonnes et ladite matrice de ladite première couche forment respectivement des jonctions passantes et des jonctions bloquantes avec ladite seconde couche, du fait de la différence de concentrations en manganèse et donc de dopage p entre les deux zones.

Selon un second mode de réalisation de l'invention, ledit composant est sensible à un champ magnétique et il peut s'agir un capteur de champ magnétique, qui comporte une couche mince formée d'un semi-conducteur ferromagnétique selon l'invention tel que défini ci-dessus, pour la détection ou la mesure dudit champ par mesure d'un effet de magnétorésistance vis-à-vis d'un champ magnétique appliqué perpendiculairement à la couche mince ou dans le plan de celle-ci.

On notera que ce composant permet de s'affranchir du phénomène de « super-paramagnétisme » qui caractérise les systèmes dilués à base de nanoparticules, et que la magnétorésistance mesurée selon l'invention reste élevée même à température ambiante contrairement à ces systèmes dilués, ce qui confère à ce composant selon l'invention d'excellentes capacités pour mesurer les champs magnétiques.

Une première utilisation selon l'invention d'un semi-conducteur ferromagnétique tel que défini ci-dessus consiste à injecter ou collecter par contact un courant de porteurs polarisés en spins dans ou depuis un autre semi-conducteur à base de silicium, de germanium ou d'un alliage de ces derniers, à une température égale ou supérieure à 350 K et pouvant être égale ou supérieure à 400 K.

Une seconde utilisation selon l'invention d'un semi-conducteur ferromagnétique tel que défini ci-dessus consiste à mesurer un champ magnétique par mesure d'un effet de magnétorésistance dans ledit semi-conducteur, à une température égale ou supérieure à 350 K et pouvant être égale ou supérieure à 400 K.

On notera que ledit semi-conducteur ferromagnétique selon l'invention peut également être utilisé comme élément magnétique dans des dispositifs de type vanne de spin, ou bien comme une région aimantée source d'un champ magnétique pour des applications dans l'enregistrement magnétique à haute densité.

Les caractéristiques précitées de la présente invention, ainsi que d'autres, seront mieux comprises à la lecture de la description suivante de plusieurs exemples de réalisation de l'invention, donnés à titre illustratif et non limitatif, ladite description étant réalisée en relation avec les dessins joints, parmi lesquels :
la figure 1 est un cliché obtenu au microscope d'un semi-conducteur ferromagnétique selon l'invention observé en coupe transversale latérale,
la figure 2 est un cliché obtenu au microscope du semi-conducteur ferromagnétique de la figure 1 observé en vue de dessus, et
la figure 3 est une vue schématique en coupe transversale latérale d'un composant électronique de type diode pour l'injection ou la collecte de spins dans ou depuis un autre semi-conducteur par exemple du groupe IV, selon un premier mode de mise en oeuvre d'un semi-conducteur ferromagnétique selon l'invention.

On va décrire ci-après un exemple de fabrication de semi-conducteurs ferromagnétiques selon l'invention de type GeMn, dans chacun desquels la phase ferromagnétique discontinue a été obtenue par Epitaxie par Jets Moléculaires (« EJM » en abrégé) à basse température. Dans ce mode de réalisation, on a opéré sous « ultra-vide », et l'on a fait évaporer le germanium et le manganèse sur un substrat de germanium ou de silicium monocristallin, à partir de sources solides correspondant respectivement à ces deux éléments métalliques.

On a suivi la procédure de croissance suivante :
a) désoxydation du substrat, selon une procédure standard bien connue de l'homme de l'art,
b) dépôt sur ce substrat désoxydé d'une couche « tampon » de germanium d'épaisseur comprise entre 20 nm et 50 nm à une température du substrat égale à 180° C, de sorte à obtenir une surface la plus lisse possible à l'échelle atomique pour la croissance bidimensionnelle du germanium-manganèse, et
c) dépôt d'une couche de GeMn d'épaisseur égale à 80 nm, à une température de 100° C pour le substrat ainsi traité.

On a réalisé ce dépôt de GeMn avec des pressions partielles de germanium et manganèse dans le flux au niveau du substrat respectivement égales à 1,8 10⁻⁸ Torr (soit 2,4 µPa) et à 2,5 10⁻⁹ Torr (soit 0,3 µPa). On a ainsi obtenu une vitesse de dépôt de l'ordre de 0,02 nm/ s.

Dans ces conditions de croissance, on a obtenu à plusieurs reprises des semi-conducteurs GeMn incorporant chacun ladite phase discontinue, qui se présentent sous la forme d'une couche mince dans laquelle on a observé une modulation latérale de la composition en manganèse.

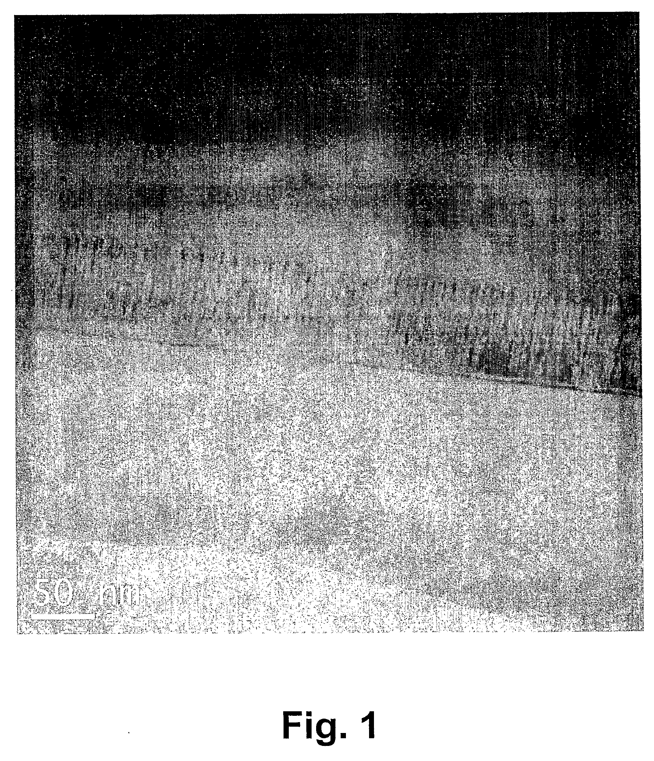

Comme cela est illustré dans la vue en coupe de la figure 1, cette modulation latérale prend la forme de colonnes qui sont sensiblement perpendiculaires au plan de la couche mince et qui sont chacune constituées d'un alliage plus riche en manganèse que la matrice qui les entoure.

Des mesures ont établi que chaque couche mince selon l'invention ainsi obtenue, qui présente une épaisseur de 80 nm, comprend en moyenne 6 % de manganèse en fraction atomique. Quant aux colonnes riches en manganèse, elles présentent chacune une fraction atomique d'environ 34 % en manganèse, pour un diamètre moyen de colonne sensiblement égal à 3 nm.

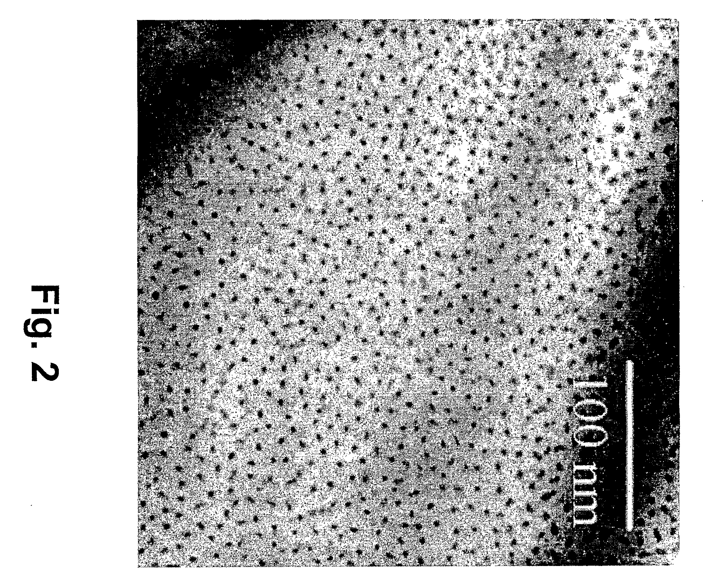

Comme cela est illustré dans la vue de dessus de la figure 2, on a pu vérifier que ces colonnes sont réparties de façon irrégulière au sein de la couche mince de chaque semi-conducteur GeMn obtenu, et qu'elles sont espacées entre elles d'une distance moyenne de l'ordre de 10 nm.

Par les méthodes bien connues de l'homme de l'art, on a établi le ferromagnétisme de chaque couche mince ainsi obtenue et son attribution à une phase discontinue ferromagnétique et semi-conductrice, et non à des inclusions ferromagnétiques sous forme de précipités comme dans le cas des semi-conducteurs magnétique dilués.

A cet effet, on a utilisé en combinaison, pour les semi-conducteurs GeMn sous forme de films ainsi obtenus :
- des mesures de l'aimantation en fonction de la température, à l'aide d'un magnétomètre dit à « SQUID », pour la mesure de la température de Curie de ces semi-conducteurs GeMn, et
- des mesures de transport électrique au moyen d'un banc de magnéto-transport équipé d'un cryostat et d'une bobine supraconductrice avec des intensités de champ magnétiques allant de 0 à 9 Tesla, pour mettre en évidence un effet Hall Extraordinaire « EHE » dans ces films semi-conducteurs GeMn.

On a obtenu les résultats suivants pour ces films de GeMn.

Chaque film de GeMn obtenu présentait une aimantation finie de 90 kA/m à 400 K, mesurée par ladite technique « SQUID ». La température de Curie de chaque film était donc clairement supérieure à 400 K.

De plus, on a vérifié que chaque film de GeMn présentait un effet Hall extraordinaire « EHE » prononcé (l'angle de Hall à saturation atteint 37°) jusqu'à une température de 300 K. Cet « EHE » se manifeste d'une manière connue par une non-linéarité de la résistivité de Hall mesurée à faible intensité de champ magnétique (< 2 Tesla). L'observation d'un tel effet Hall extraordinaire constitue une preuve de la polarisation en spin des porteurs impliqués dans le transport électrique, au sein de chaque film semi-conducteur GeMn.

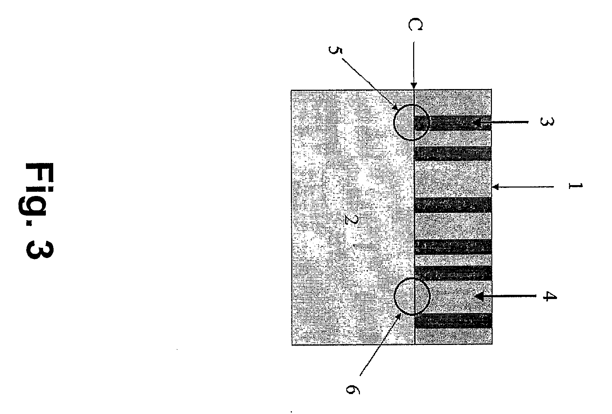

Est illustrée à la figure 3 une utilisation particulièrement avantageuse de ces films semi-conducteurs de type GeMn à température de Curie très élevée présentant une modulation latérale de la composition en Mn, comme injecteur ou collecteur de porteurs polarisés en spin dans ou depuis un autre semi-conducteur par exemple en germanium ou en silicium pour former un composant électronique C de type diode.

Le composant C comporte une première couche mince 1 formée du semi-conducteur GeMn obtenu selon le procédé précité, une seconde couche mince 2 formée par ledit autre semi-conducteur et au contact de laquelle est appliquée la première couche 1, et la source de courant de porteurs (non illustrée), pour que la phase ferromagnétique et riche en Mn de la première couche mince 1 émette ou reçoive ce courant polarisé en spin vers ou depuis la seconde couche mince 2, respectivement.

En l'absence de dopage complémentaire à celui introduit par le manganèse, le manganèse constituant un double accepteur dans le germanium, les porteurs sont nécessairement des trous. Pour réaliser l'injection ou la collecte sélective de trous polarisés en spin dans la seconde couche mince 2 (fortement dopée n) à partir des colonnes 3 ferromagnétiques formant ladite phase, on a utilisé le principe d'une diode à effet tunnel d'Esaki, qui utilise le fait que la transparence d'une diode tunnel p-n augmente avec le dopage des couches.

Par conséquent, la diode tunnel obtenue est transparente au niveau de chaque colonne 3 enrichie en manganèse en formant une jonction passante 5 (car chaque colonne 3 est fortement dopée p), et sera isolante au niveau de la matrice 4 appauvrie en manganèse en formant une jonction bloquante 6 (car la matrice 4 est faiblement dopée p).

De cette façon, le courant de porteurs provient très majoritairement des colonnes 3, ce qui est recherché pour obtenir l'injection d'un courant de porteurs polarisés en spin vers l'électrode inférieure 2 du composant C, avantageusement choisie à base de germanium, de silicium ou d'un de leurs alliages, jusqu'à une température de 400 K. Il en est de même dans le cas où le courant provient de l'électrode inférieure 2 : la collecte de porteurs polarisés en spin se fait très majoritairement dans les colonnes 3.

On a par ailleurs cherché à utiliser les films semi-conducteurs GeMn obtenus par le procédé décrit ci-dessus comme des capteurs de champ de type magnétorésistifs.

Dans chaque film de GeMn de 80 nm d'épaisseur ainsi obtenu, on a mesuré de forts effets de magnétorésistance pour un champ appliqué perpendiculairement à la couche mince et pour un transport planaire, cette couche mince ayant été disposée au contact d'électrodes en or.

On a en effet mesuré, à température ambiante, une magnétorésistance positive de + 50 %, pour une intensité de champ magnétique variant de 0 à 3 Tesla (cette magnétorésistance devient linéaire en champ magnétique et augmente fortement jusqu'à quelques milliers de %, lorsqu'on réduit la température).

## Revendications

1. Semi-conducteur ferromagnétique (1) du groupe IV comprenant au moins un élément magnétique choisi dans le groupe constitué par le manganèse, le fer, le cobalt, le nickel et le chrome, ledit semi-conducteur ferromagnétique formant une couche mince et présentant une température de Curie égale ou supérieure à 350 K, de préférence égale ou supérieure à 400 K, et **caractérisé en ce que** ledit semi-conducteur présente une matrice (4) pauvre en cet ou ces éléments(s) magnétique(s), à l'intérieur de laquelle est formée une phase discontinue (3) qui est riche en cet ou ces élément(s) magnétique et qui est ferromagnétique jusqu'à ladite température de Curie, de sorte à générer une modulation latérale de la composition dudit semi-conducteur dans le plan de ladite couche mince.

2. Semi-conducteur ferromagnétique (1) selon la revendication 1, **caractérisé en ce qu'**il présente un effet Hall extraordinaire (EHE) à une température supérieure à 300 K.

3. Semi-conducteur ferromagnétique (1) selon une des revendications précédentes, **caractérisé en ce que** ledit ou l'un au moins desdits élément(s) magnétique(s) est le manganèse.

4. Semi-conducteur ferromagnétique (1) selon une des revendications précédentes, **caractérisé en ce qu'**il est à base d'au moins un autre élément choisi dans le groupe constitué par le germanium, le silicium et leurs alliages.

5. Semi-conducteur ferromagnétique (1) selon les revendications 3 et 4, **caractérisé en ce qu'**il est à base de germanium et de manganèse.

6. Semi-conducteur ferromagnétique (1) selon la revendication 5, **caractérisé en ce qu'**il est totalement dépourvu de phase métallique de formule Ge₃Mn₅.

7. Semi-conducteur ferromagnétique (1) selon la revendication 1, **caractérisé en ce que** la fraction atomique de cet ou ces élément(s) magnétique(s) dans ladite phase (3) est comprise entre 5 % et 50 %.

8. Semi-conducteur ferromagnétique (1) selon les revendications 5 et 7, **caractérisé en ce que** la fraction atomique de cet ou ces élément(s) magnétique(s) dans ladite phase (3) et dans ladite matrice (4) est comprise entre 20 % et 40 % et entre 1 % et 10 %, respectivement.

9. Semi-conducteur ferromagnétique (1) selon revendications 1 et 9, **caractérisé en ce que** ladite phase (3) comprend une répartition irrégulière de zones volumiques riches en cet ou ces élément(s) magnétique(s) qui sont séparées entre elles par ladite matrice (4).

10. Semi-conducteur ferromagnétique (1) selon la revendication 9, **caractérisé en ce que** lesdites zones volumiques sont respectivement formées par des colonnes (3) sensiblement perpendiculaires à la surface de ladite couche mince, lesdites colonnes (3) présentant de préférence un diamètre moyen compris entre 1 nm et 10 nm, pour une épaisseur de ladite couche mince comprise entre 60 nm et 100 nm, lesdites colonnes (3) étant séparées entre elles d'une distance moyenne de préférence comprise entre 5 nm et 15 nm.

11. Procédé de fabrication d'un semi-conducteur ferromagnétique (1) selon une des revendications précédentes, **caractérisé en ce qu'**il consiste en une épitaxie par jets moléculaires comprenant un dépôt simultané d'au moins ledit élément magnétique choisi dans le groupe constitué par le manganèse, le fer, le cobalt, le nickel et le chrome et d'au moins un autre élément choisi dans le groupe IVA de la classification périodique, sur un substrat dont la température pendant la croissance des cristaux est comprise entre 80° C et 200° C, pour l'obtention d'une couche mince dudit semi-conducteur du groupe IV.

12. Procédé de fabrication selon la revendication 11, **caractérisé en ce qu'**on réalise ledit dépôt desdits éléments en utilisant un rapport moyen [vitesse de dépôt du ou des élément(s) magnétique(s) / vitesses totales de dépôt desdits éléments] qui est compris entre 5 % et 10 %.

13. Procédé de fabrication selon la revendication 11 ou 12, **caractérisé en ce que** ledit ou l'un au moins desdits élément(s) magnétique(s) est le manganèse, le(s)dit(s) autre(s) élément(s) déposés simultanément étant de préférence le germanium, le silicium ou un alliage de ces derniers.

14. Procédé de fabrication selon la revendication 13, **caractérisé en ce que** ledit élément magnétique et ledit autre élément déposés simultanément sont respectivement le manganèse et le germanium, pour l'obtention d'un semi-conducteur (1) à base de germanium et de manganèse.

15. Procédé de fabrication selon la revendication 14, **caractérisé en ce qu'**il comprend un dépôt sur ledit substrat d'une couche « tampon » de germanium, antérieurement audit dépôt simultané de germanium et de manganèse pour l'obtention de ladite couche mince.

16. Procédé de fabrication selon une des revendications 11 à 15, **caractérisé en ce que** ledit substrat est à base d'un matériau choisi dans le groupe constitué par le germanium, le silicium et les alliages de ces derniers.

17. Composant électronique (C) formant une diode pour l'injection ou la collecte de spins dans ou depuis un autre semi-conducteur, respectivement, ou bien de type élément sensible à un champ magnétique, **caractérisé en ce qu'**il comporte un semi-conducteur ferromagnétique (1) selon une des revendications 1 à 10.

18. Composant électronique (C) selon la revendication 17, ledit composant formant une diode pour l'injection ou la collecte de spins dans ou depuis un autre semi-conducteur, **caractérisé en ce qu'**il comporte :
- une première couche mince formée d'un premier semi-conducteur ferromagnétique (1),
- une seconde couche mince (2) formée d'un second semi-conducteur à base de silicium, de germanium ou d'un de leurs alliages, au contact de laquelle est appliquée ladite première couche mince, et
- une source de courant de porteurs couplée à ladite première couche pour, dans un premier cas, en extraire sélectivement un courant polarisé en spin et pour l'injecter dans ladite seconde couche ou bien, dans un second cas, pour extraire sélectivement un courant polarisé en spin de ladite seconde couche et l'injecter dans ladite première couche,
**caractérisé en ce que** ledit premier semi-conducteur est tel que défini à l'une des revendications 6 à 11, pour que ladite phase ferromagnétique et riche en élément(s) magnétique(s) dudit premier semi-conducteur émette ou reçoive ce courant polarisé en spin vers ou depuis ledit second semi-conducteur, respectivement selon lesdits premier ou second cas.

19. Composant électronique (C) selon la revendication 18, **caractérisé en ce que** ledit premier semi-conducteur ferromagnétique (1) est tel que défini à la revendication 9 ou 10, pour que lesdites première et seconde couche minces (1 et 2) appliquées l'une sur l'autre forment une diode d'Esaki à effet tunnel, dans laquelle lesdites colonnes (3) et ladite matrice (4) de ladite première couche forment respectivement des jonctions passantes (5) et des jonctions bloquantes (6) avec ladite seconde couche.

20. Composant électronique sensible à un champ magnétique selon la revendication 17, notamment pour constituer un capteur de champ magnétique, **caractérisé en ce qu'**il comporte une couche mince formée d'un semi-conducteur ferromagnétique (1) selon une des revendications 1 à 10, pour la détection ou la mesure dudit champ par mesure d'un effet de magnétorésistance vis-à-vis d'un champ magnétique appliqué perpendiculairement à ladite couche mince ou dans le plan de cette dernière.

21. Utilisation d'un semi-conducteur ferromagnétique (1) selon une des revendications 1 à 10 pour injecter ou collecter par contact un courant de porteurs polarisés en spins, respectivement dans ou depuis un autre semi-conducteur à base de silicium, de germanium ou d'un alliage de ces
derniers, à une température égale ou supérieure à 350 K et pouvant être égale ou supérieure à 400 K.

22. Utilisation d'un semi-conducteur ferromagnétique (1) selon une des revendications 1 à 10 pour mesurer un champ magnétique par mesure d'un effet de magnétorésistance dans ledit semi-conducteur, lequel présente les propriétés de magnétorésistance recherchées jusqu'à une température égale ou supérieure à 350 K et pouvant être égale ou supérieure à 400 K.

## Patentansprüche

1. Ferromagnetischer Halbleiter (1) der Gruppe IV, umfassend mindestens ein magnetisches Element, ausgewählt aus der Gruppe, die von dem Mangan, dem Eisen, dem Kobalt, dem Nickel und dem Chrom gebildet ist, wobei der ferromagnetische Halbleiter eine Dünnschicht bildet und eine Curie-Temperatur von gleich oder über 350 K, vorzugsweise von gleich oder über 400 K, aufweist und **dadurch gekennzeichnet ist, dass** der Halbleiter eine an diesem oder diesen magnetischen Elementen arme Matrix (4) aufweist, in deren Innern eine diskontinuierliche Phase (3) gebildet ist, die an diesem oder diesen magnetischen Elementen reich ist und die bis zu der Curie-Temperatur ferromagnetisch ist, so dass eine seitliche Modulation der Zusammensetzung des Halbleiters in der Ebene der Dünnschicht erzeugt wird.

2. Ferromagnetischer Halbleiter (1) nach Anspruch 1, **dadurch gekennzeichnet, dass** er bei einer Temperatur über 300 K einen außerordentlichen Hall-Effekt (EHE) aufweist.

3. Ferromagnetischer Halbleiter (1) nach einem der vorangehenden Ansprüche, **dadurch gekennzeichnet, dass** das oder mindestens eines der magnetischen Elemente das Mangan ist.

4. Ferromagnetischer Halbleiter (1) nach einem der vorangehenden Ansprüche, **dadurch gekennzeichnet, dass** er auf der Basis von mindestens einem anderen Element ist, das aus der Gruppe ausgewählt ist, die von dem Germanium, dem Silizium und deren Legierungen gebildet ist.

5. Ferromagnetischer Halbleiter (1) nach den Ansprüchen 3 und 4, **dadurch gekennzeichnet, dass** er auf der Basis von Germanium und von Mangan ist.

6. Ferromagnetischer Halbleiter (1) nach Anspruch 5, **dadurch gekennzeichnet, dass** er vollkommen frei von metallischer Phase der Formel Ge₃Mn₅ ist.

7. Ferromagnetischer Halbleiter (1) nach Anspruch 1, **dadurch gekennzeichnet, dass** die Atomfraktion dieses oder dieser ferromagnetischen Elemente in der Phase (3) zwischen 5 % und 50 % inklusive beträgt.

8. Ferromagnetischer Halbleiter (1) nach den Ansprüchen 5 und 7, **dadurch gekennzeichnet, dass** die Atomfraktion dieses oder dieser magnetischen Elemente in der Phase (3) und in der Matrix (4) jeweils zwischen 20 % und 40 % und zwischen 1 % und 10 % inklusive beträgt.

9. Ferromagnetischer Halbleiter (1) nach den Ansprüchen 1 und 8, **dadurch gekennzeichnet, dass** die Phase (3) eine unregelmäßige Verteilung von Volumenzonen umfasst, die an diesem oder diesen magnetischen Elementen reich sind, die voneinander von der Matrix (4) getrennt sind.

10. Ferromagnetischer Halbleiter (1) nach Anspruch 9, **dadurch gekennzeichnet, dass** die Volumenzonen jeweils von etwa senkrechten Säulen (3) auf der Oberfläche der Dünnschicht gebildet sind, wobei die Säulen (3) einen mittleren Durchmesser zwischen 1 nm und 10 nm inklusive für eine Dicke der Dünnschicht zwischen 60 nm und 100 nm inklusive aufweisen, wobei die Säulen (3) voneinander in einem durchschnittlichen Abstand vorzugsweise zwischen 5 nm und 15 nm inklusive getrennt sind.

11. Herstellungsverfahren eines ferromagnetischen Halbleiters (1) nach einem der vorangehenden Ansprüche, **dadurch gekennzeichnet, dass** er aus einer Epitaxie durch Molekularstrahlen besteht, umfassend ein gleichzeitiges Aufbringen von mindestens dem magnetischen Element, ausgewählt aus der Gruppe, die von dem Mangan, dem Eisen, dem Kobalt, dem Nickel und dem Chrome gebildet ist, und von mindestens einem anderen Element, das aus der Gruppe IVA des Periodensystems ausgewählt ist, auf ein Substrat, dessen Temperatur während des Wachstums der Kristalle zwischen 80 °C und 200 °C inklusive beträgt, für den Erhalt einer Dünnschicht des Halbleiters der Gruppe IV.

12. Herstellungsverfahren nach Anspruch 11, **dadurch gekennzeichnet, dass** die Elemente bei Anwendung eines durchschnittlichen Verhältnisses [Geschwindigkeit des Aufbringens des oder der magnetischen Elemente / Gesamtgeschwindigkeiten des Aufbringens der Elemente] zwischen 5 % und 10 % inklusive aufgebracht werden.

13. Herstellungsverfahren nach Anspruch 11 oder 12, **dadurch gekennzeichnet, dass** das eine oder mindestens eines der magnetischen Elemente das Mangan ist, wobei die anderen gleichzeitig aufgebrachten Elemente vorzugsweise das Germanium, das Silizium oder eine Legierung letzterer sind.

14. Herstellungsverfahren nach Anspruch 13, **dadurch gekennzeichnet, dass** das magnetische Element und die anderen gleichzeitig aufgebrachten Elemente für den Erhalt eines Halbleiters (1) auf der Basis von Germanium und von Mangan jeweils das Mangan und das Germanium sind.

15. Herstellungsverfahren nach Anspruch 14, **dadurch gekennzeichnet, dass** es vor dem gleichzeitigen Aufbringen von Germanium und von Mangan für den Erhalt der Dünnschicht das Aufbringen einer Germanium-"Pufferschicht" auf das Substrat umfasst.

16. Herstellungsverfahren nach einem der Ansprüche 11 bis 15, **dadurch gekennzeichnet, dass** das Substrat auf der Basis eines Materials ist, das aus der Gruppe ausgewählt ist, die von dem Germanium, dem Silizium und den Legierungen letzterer gebildet ist.

17. Elektronische Komponente (C), die eine Diode für das Einleiten oder das Sammeln von Spins in oder aus einem anderen jeweiligen Halbleiter oder des Typs Element, das für ein Magnetfeld sensibel ist, bildet, **dadurch gekennzeichnet, dass** sie einen ferromagnetischen Halbleiter (1) nach einem der Ansprüche 1 bis 10 aufweist.

18. Elektronische Komponente (C) nach Anspruch 17, wobei die Komponente eine Diode für das Einleiten oder das Sammeln von Spins in oder aus einem anderen Halbleiter bildet, **dadurch gekennzeichnet, dass** sie aufweist:
- eine erste Dünnschicht, gebildet von einem ersten ferromagnetischen Halbleiter (1),
- eine zweite Dünnschicht (2), gebildet von einem zweiten Halbleiter auf der Basis von Silizium, von Germanium oder einer ihrer Legierungen, wobei die erste Dünnschicht im Kontakt mit ihr aufgebracht wird, und
- eine an die erste Schicht gekoppelte Stromquelle von Trägern, um, in einem ersten Fall, daraus selektiv einen spinpolarisierten Strom zu extrahieren und ihn in die zweite Schicht einzuleiten oder, um, in einem zweiten Fall, aus der zweiten Schicht selektiv einen spinpolarisierten Strom zu extrahieren und ihn in die erste Schicht einzuleiten,
**dadurch gekennzeichnet, dass** der erste Halbleiter einem der Ansprüche 6 bis 11 entspricht, damit die ferromagnetische und an magnetischem Element/magnetischen Elementen reiche Phase des ersten Halbleiters diesen spinpolarisierten Strom jeweils gemäß dem ersten oder zweiten Fall an den zweiten Halbleiter sendet oder von ihm erhält.

19. Elektronische Komponente (C) nach Anspruch 18, **dadurch gekennzeichnet, dass** der erste ferromagnetische Halbleiter (1) einem der Ansprüche 9 oder 10 entspricht, damit die aufeinander angeordnete erste und zweite Dünnschicht (1 und 2) eine Esaki-Diode mit Tunneleffekt bilden, in welcher die Säulen (3) und die Matrix (4) der ersten Schicht jeweils durchgängige Verbindungen (5) und blockierende Verbindungen (6) mit der zweiten Schicht bilden.

20. Elektronische Komponente, sensibel für ein Magnetfeld nach Anspruch 17, insbesondere um einen Magnetfeldsensor zu bilden, **dadurch gekennzeichnet, dass** sie eine von einem ferromagnetischen Halbleiter (1) nach einem der Ansprüche 1 bis 10 gebildete Dünnschicht für die Ermittlung oder das Messen des Feldes durch Messen eines Magnetresistenzeffekts gegenüber einem Magnetfeld, das senkrecht auf die Dünnschicht oder in der Ebene letzterer angewendet wird, aufweist.

21. Verwendung eines ferromagnetischen Halbleiters (1) nach einem der Ansprüche 1 bis 10 zum Einleiten oder Sammeln durch Kontakt eines Stroms spinpolarisierter Träger jeweils in einen oder aus einem Halbleiter auf der Basis von Silizium, von Germanium oder einer Legierung letzterer bei einer Temperatur von gleich oder über 350 K und möglicherweise von gleich oder über 400 K.

22. Verwendung eines ferromagnetischen Halbleiters (1) nach einem der Ansprüche 1 bis 10 zum Messen eines Magnetfelds durch Messen eines Magnetresistenzeffekts in dem Halbleiter, welcher die gewünschten Magnetresistenzeigenschaften bis zu einer Temperatur von gleich oder über 350 K und möglicherweise von gleich oder über 400 K aufweist.

## Claims

1. A ferromagnetic semiconductor (1) of group IV, comprising at least one magnetic element chosen from the group formed by manganese, iron, cobalt, nickel and chromium, said semiconductor forming a thin film and having a Curie temperature of 350 K or higher, preferably of 400 K or higher, and **characterized in that** said semiconductor has a matrix (4) depleted in this magnetic element or these magnetic elements, within which matrix a discontinuous phase (3), which is rich in this magnetic element or these magnetic elements and is ferromagnetic up to said Curie temperature, is formed so as to generate a lateral modulation of the composition of said semiconductor in the plane of said thin film.

2. The ferromagnetic semiconductor (1) as claimed in claim 1, **characterized in that** it has an extraordinary Hall effect (EHE) at a temperature above 300 K.

3. The ferromagnetic semiconductor (1) as claimed in one of the preceding claims, **characterized in that** said magnetic element or at least one of said magnetic elements is manganese.

4. The ferromagnetic semiconductor (1) as claimed in one of the preceding claims, **characterized in that** it is based on at least one other element chosen from the group formed by germanium, silicon and alloys thereof.

5. The ferromagnetic semiconductor (1) as claimed in claims 3 and 4, **characterized in that** it is based on germanium and manganese.

6. The ferromagnetic semiconductor (1) as claimed in claim 5, **characterized in that** it is completely free of the metallic phase of formula Ge₃Mn₅.

7. The ferromagnetic semiconductor (1) as claimed in claim 1, **characterized in that** the atomic fraction of this magnetic element or these magnetic elements in said phase (3) is between 5% and 50%.

8. The ferromagnetic semiconductor (1) as claimed in claims 4 and 7, **characterized in that** the atomic fraction of this magnetic element or these magnetic elements in said phase (3) and in said matrix (4) is between 20% and 40% and between 1% and 10%, respectively.

9. The ferromagnetic semiconductor (1) as claimed in the claims 1 and 8, **characterized in that** said phase (3) has an irregular distribution of volume zones rich in this magnetic element or these magnetic elements, said zones being separated from one another by said matrix (4).

10. The ferromagnetic semiconductor (1) as claimed in claim 9, **characterized in that** said volume zones are formed respectively by columns (3) approximately perpendicular to the surface of said thin film, said columns (3) having an average diameter of between 1 nm and 10 nm for a thickness of said thin film of between 60 nm and 100 nm, said columns (3) being separated from one another by an average distance of between 5 nm and 15 nm.

11. A process for fabricating a ferromagnetic semiconductor (1) as claimed in one of the preceding claims, **characterized in that** it consists of a molecular beam epitaxy comprising the simultaneous deposition of at least said magnetic element chosen from the group formed by manganese, iron, cobalt, nickel and chromium and of at least one other element chosen from group IVA of the Periodic Table, on a substrate whose temperature during the growth of the crystals is between 80°C and 200°C, in order to obtain a thin film of said semiconductor of group IV.

12. The fabrication process as claimed in claim 11, **characterized in that** said deposition of said elements is carried out using an average [deposition rate for the magnetic element or elements/total deposition rates for said elements] ratio which is between 5% and 10%.

13. The fabrication process as claimed in claim 11 or 12, **characterized in that** said magnetic element or at least one of said magnetic elements is manganese, said other element(s) deposited simultaneously being germanium, silicon or an alloy of these.

14. The fabrication process as claimed in claim 13, **characterized in that** said magnetic element and said other element deposited simultaneously are manganese and germanium respectively, so as to obtain a semiconductor (1) based on germanium and manganese.

15. The fabrication process as claimed in claim 14, **characterized in that** it includes the deposition of a germanium "buffer" layer on said substrate, prior to said simultaneous deposition of germanium and manganese for obtaining said thin film.

16. The fabrication process as claimed in one of claims 11 to 15, **characterized in that** said substrate is based on a material chosen from the group formed by germanium, silicon and alloys of these.

17. An electronic component (C) forming a diode for injecting spins into or collecting spins from another semiconductor respectively, or else of the type comprising an element sensitive to a magnetic field, **characterized in that** it comprises a ferromagnetic semiconductor (1) as claimed in one of claims 1 to 10.

18. The electronic component (C) as claimed in claim 17, said component forming a diode for injecting spins into or for collecting spins from another semiconductor, **characterized in that** it comprises:
- a first thin film formed from a first ferromagnetic semiconductor (1);
- a second thin film (2) formed from a second semiconductor based on silicon, germanium or one of their alloys, in contact with which said first thin film is applied; and
- a carrier current source coupled to said first film for, in a first case, selectively extracting therefrom a spin-polarized current and for injecting it into said second film, or else, in a second case, for selectively extracting a spin-polarized current from said second film and injecting it into said first film,
**characterized in that** said first semiconductor is as defined in one of claims 6 to 11, in order for said ferromagnetic phase rich in the magnetic element(s) of said first semiconductor to send this spin-polarized current to said second semiconductor or to receive said current from the latter, depending on said first case or second case respectively.

19. The electronic component (C) as claimed in claim 18, **characterized in that** said first ferromagnetic semiconductor (1) is as defined in one of claims 9 or 10, in order for said first and second thin films (1 and 2) applied one to the other to form an Esaki tunnel diode in which said columns (3) and said matrix (4) of said first film form, with said second film, conducting junctions (5) and blocking junctions (6) respectively.

20. The magnetic-field-sensitive electronic component as claimed in claim 17, especially for constituting a magnetic field sensor, **characterized in that** it includes a thin film formed from a ferromagnetic semiconductor (1) as claimed in one of claims 1 to 10, for the detection or measurement of said field by measuring a magnetoresistance effect with respect to a magnetic field applied perpendicular to said thin film or in the plane of the latter.

21. The use of a ferromagnetic semiconductor (1) as claimed in one of claims 1 to 10 for the injection or collection by contact of a current of spin-polarized carriers, respectively into or from another semiconductor based on silicon and germanium or on an alloy of these, at a temperature equal to or greater than 350 K and possibly equal to or greater than 400 K.

22. The use of a ferromagnetic semiconductor (1) as claimed in one of claims 1 to 10 for the measurement of a magnetic field by measuring a magnetoresistance effect in said semiconductor, which has the desired magnetoresistance properties up to a temperature equal to or greater than 350 K and possibly equal to or greater than 400 K.
